(19) Europäisches Patentamt
European Patent Office
Office européen des brevets

(11) **EP 1 676 140 B1**

(12) **FASCICULE DE BREVET EUROPEEN**

(45) Date de publication et mention
de la délivrance du brevet:
**24.01.2007 Bulletin 2007/04**

(21) Numéro de dépôt: **04791158.1**

(22) Date de dépôt: **06.10.2004**

(51) Int Cl.:
***G01R 19/32*** *(2006.01)*    ***G01R 19/00*** *(2006.01)*

(86) Numéro de dépôt international:
**PCT/EP2004/052447**

(87) Numéro de publication internationale:
**WO 2005/038472 (28.04.2005 Gazette 2005/17)**

(54) **DISPOSITIF DE MESURE NON DISSIPATIF DU COURANT DANS UNE INDUCTANCE**

EINRICHTUNG ZUR NICHTDISSIPATIVEN MESSUNG VON STROM IN EINEM INDUKTIVEN WIDERSTAND

DEVICE FOR NON-DISSIPATIVE MEASUREMENT OF CURRENT IN AN INDUCTIVE RESISTOR

(84) Etats contractants désignés:
**DE FR GB IT**

(30) Priorité: **21.10.2003 FR 0312294**

(43) Date de publication de la demande:
**05.07.2006 Bulletin 2006/27**

(73) Titulaire: **Thales**
**92200 Neuilly Sur Seine (FR)**

(72) Inventeurs:
• **BLANC, Flavien,**
**THALES Intellectual Property**
**F-94117 ARCUEIL Cedex (FR)**

• **TAURAND, Christophe,**
**THALES Intellectual Property**
**F-94117 ARCUEIL Cedex (FR)**

(74) Mandataire: **Lucas, Laurent Jacques**
**Marks & Clerk France**
**31-33 Avenue Aristide Briand**
**94117 Arcueil Cedex (FR)**

(56) Documents cités:
**US-A- 4 910 455          US-A- 5 501 517**
**US-A1- 2003 071 636      US-B1- 6 469 481**

**Description**

L'invention concerne un dispositif de mesure non dissipatif, de faible coût et encombrement réduit, du courant traversant une inductance insérée dans un dispositif électrique ou électronique.

Dans certaines applications électroniques il est nécessaire de mesurer la valeur du courant dans les inductances avec une bonne précision et en perturbant le moins possible le dispositif dans lequel se trouve insérée l'inductance. Nous pouvons citer par exemple la mesure du courant dans les inductances des alimentations à découpage, entre autres, les hacheurs série à découpage abaisseurs ou élévateurs de tension (respectivement « buck converter » et « boost converter » en langue anglaise).

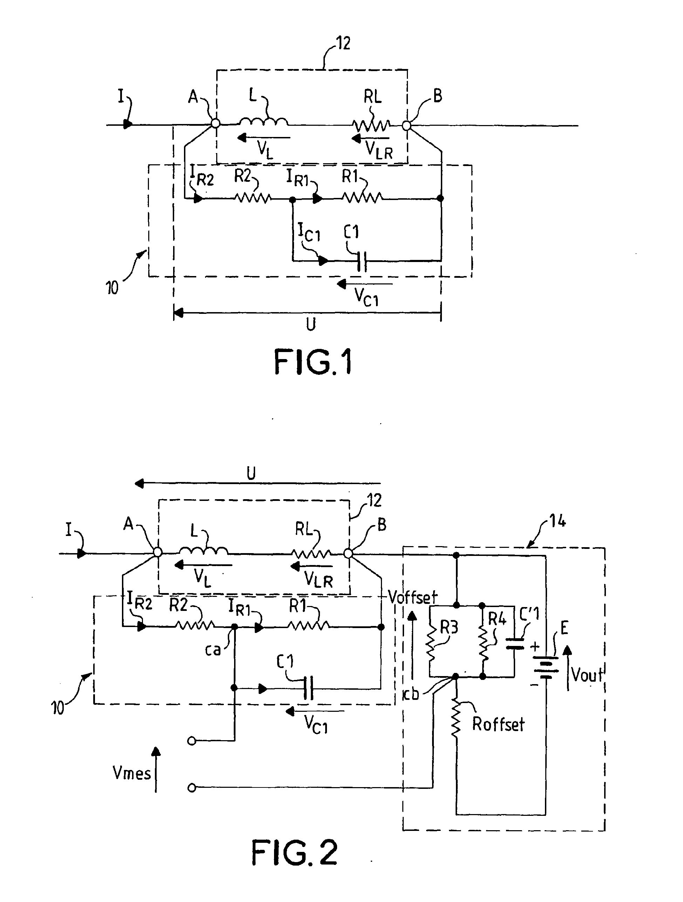

La méthode classique qui est la plus utilisée consiste à placer un shunt de mesure en série avec l'inductance ce qui permet d'obtenir l'image du courant dans l'inductance en mesurant la tension aux bornes du shunt. Cette solution présente l'avantage d'être simple à mettre en oeuvre, en revanche elle comporte un inconvénient majeur. En effet la puissance dissipée dans le shunt contribue à dégrader le rendement global du convertisseur ce qui n'est pas toujours acceptable, ceci est d'autant plus vrai que la tension de sortie du dispositif de conversion d'énergie est faible. Pour éviter cette contrainte, une solution de mesure de courant non dissipative présentée dans la figure 1 est utilisée.

La figure 1 montre un schéma d'un dispositif de mesure 10 du courant I traversant une inductance 12. L'inductance 12 est représentée par son schéma équivalent comportant une partie réactive pure, soit la partie inductive L en série avec une résistance RL. L'inductance comporte une borne A et une borne B.

Le dispositif de mesure 10, à faible coût et très peu dissipatif, est mis en parallèle sur des bornes A et B de l'inductance 12. Le dispositif de mesure 10 comporte une résistance R2 en série avec une résistance R1 en parallèle avec une capacité C1, la résistance R2 étant connectée à la borne A, la résistance R1 à la borne B.

Le document US 6,469,481 B1 (TATEISHI) divulgue un dispositif de cet type.

Le but de ce montage de l'état de l'art est d'obtenir une tension aux bornes de la capacité C1 proportionnelle à la tension aux bornes de la résistance RL de l'inductance 12 donc proportionnelle au courant I dans l'inductance 12 (ou dans l'inductance L). Les courants dans les résistances R2 et R1 sont négligeables devant le courant I dans l'inductance 12.

Pour dimensionner les éléments du dispositif, il est important de respecter la contrainte suivante :

$$\frac{L}{RL} = \frac{R1 \cdot R2}{R1 + R2} \times C1 \quad \text{équation (1)}$$

Si la condition exprimée par l'équation (1) est vérifiée, $V_{C1}$ est l'image du courant dans l'inductance. La tension $V_{C1}$ aux bornes de C1 est donnée par la relation suivante :

$$V_{C1} = \left( \frac{R1 \cdot RL}{R1 + R2} \right) \cdot I \qquad \text{équation (2)}$$

Le dispositif de la figure 1 permet donc d'obtenir l'image d'un courant traversant une inductance à condition de connaître la valeur de la résistance intrinsèque RL de l'inductance.

On peut remarquer que l'image du courant est donnée par une équation du type : $V_{C1}(I) = a.I$ avec « a » le coefficient de proportionnalité.

Pour certaines applications, il est nécessaire que la mesure présente une tension de décalage (ou tension d'offset), c'est à dire que contrairement à l'équation précédente (2), lorsque le courant I est nul la tension $V_{C1}$ n'est pas nulle. L'équation qui traduit ce comportement est de la forme : $V_{C1}(I) = a.I + b$ avec :

« a » le coefficient de proportionnalité et « b » l'ordonnée à l'origine (tension d'offset dans notre cas).

Pour réaliser ce décalage sur la mesure, il suffit de joindre un montage supplémentaire au dispositif de la figure 1.

La figure 2 montre un dispositif de mesure du courant I dans l'inductance 12 avec un décalage de tension Voffset.

Dans le dispositif de mesure du courant de la figure 2, la tension image du courant dans l'inductance n'est plus $V_{C1}$, comme dans le dispositif de la figure 1, mais devient la tension Vmes.

Le circuit de mesure de la figure 2 comporte en plus des éléments de la figure 1, un circuit de décalage 14 ayant un générateur E de tension continue Vout connecté en parallèle, avec une résistance de décalage Roffset en série avec deux résistances en parallèle R3 et R4. Le pôle positif du générateur étant connecté au point commun des deux résistances R3 et R4 et à la borne B de l'inductance 12, le pôle négatif du générateur étant connecté à la résistance Roffset. Le générateur de tension E peut être la capacité de sortie d'un convertisseur, ce qui est le cas pour un hacheur de type Buck par exemple.

Il est également possible de placer une capacité C1' en parallèle sur R3 et R4 afin d'équilibrer les impédances sur les deux branches du dispositif de mesure.

La tension Vmes est mesurée entre le point commun ca entre les deux résistances R2 et R1 et le point commun cb entre la résistance Roffset et les deux résistances R3 et R4 en parallèle.

On peut écrire l'expression de Vmes relative au dispositif de la figure 2 :

$$Vmes = \left( \frac{R1 \cdot RL}{R1 + R2} \right) \cdot I + Vout \cdot \left( 1 - \frac{Roffset}{\frac{R3 \cdot R4}{R3 + R4} + Roffset} \right) \text{ équation (3)}$$

La tension Vout étant constante, la tension Voffset est donc également constante, l'équation obtenue est donc de la forme : Vmes(I) = a.I+b, avec :

$$a = \left( \frac{R1 \cdot RL}{R1 + R2} \right) \quad et \quad b = Vout \cdot \left( 1 - \frac{Roffset}{\frac{R3 \cdot R4}{R3 + R4} + Roffset} \right)$$

Ce type de mesure est utilisé dans les dispositifs comme les convertisseurs à découpage de l'électronique de puissance pour lesquels il est nécessaire de limiter le courant traversant les inductances. Pour cela, la tension de mesure Vmes est comparée, à l'aide d'un comparateur à seuil, à une tension de seuil Vseuil correspondant à un courant maximal Imax.

Cependant le dispositif de l'état de l'art représenté à la figure 2, présente un inconvénient majeur car la valeur de la résistance RL de l'inductance dépend de la température à laquelle elle est soumise, la mesure de courant qui est obtenue présente donc une erreur liée à la température. La conséquence est que la mesure du courant dans l'inductance et donc la limitation de courant Ilim dépend de la température.

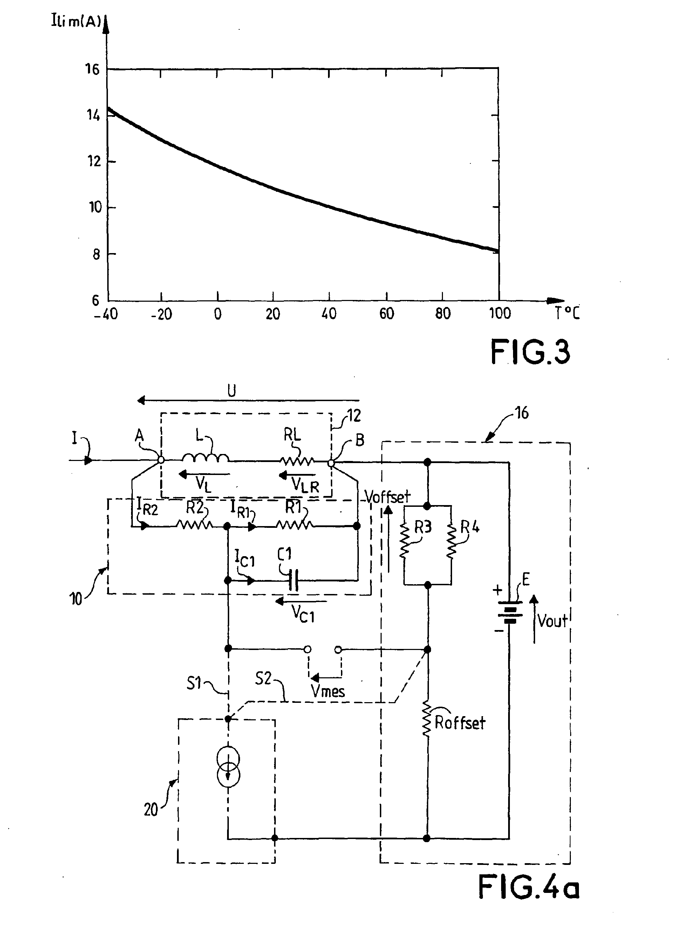

La figure 3 montre une courbe de variation du courant de limitation Ilim en fonction de la température T d'un circuit de limitation de courant comportant un comparateur à seuil et le dispositif de mesure de la figure 2. La variation du courant de limitation en fonction de la température est de 60% entre -40°C et 100°C. Une telle dispersion sur la valeur du courant de limitation entraîne un surdimensionnement du circuit de puissance pour qu'il puisse supporter la courant de limitation à température basse ce qui représente un inconvénient majeur.

Afin de pallier les inconvénients des dispositifs de la mesure du courant de l'état de l'art, l'invention propose un dispositif de mesure de courant dans une inductance destiné à être connecté en parallèle sur ladite inductance comportant deux bornes A et B, caractérisé en ce qu'il comporte :

- un réseau en parallèle avec l'inductance connecté aux bornes A et B ayant une résistance R2 en série avec une résistance R1 en parallèle avec une capacité C1,
- un circuit de décalage de tension ayant un générateur E de tension continue connecté en parallèle avec une résistance de décalage (Roffset) en série avec deux résistances en parallèle R3 et R4, le pôle positif du générateur étant connecté au point commun des deux résistances R3 et R4 et au point commun de la résistance R1 et la capacité C1 du réseau destiné à être connecté à une des deux bornes de l'inductance, le pôle négatif du générateur E étant connecté à la résistance de décalage ;
- un circuit de compensation en température comportant une source de courant contrôlée en fonction de la température, une des deux bornes de la source de courant étant connectée au pôle négatif du générateur E, l'autre borne de la source de courant étant connectée à des points différents du dispositif de mesure selon le sens de la variation du courant de la source en fonction de la température ;

et en ce que la mesure de tension Vmes, image du courant dans l'inductance, est effectuée entre le point commun des résistances R1, R2 du réseau et le point commun de la résistance de décalage et des deux résistances R3 et R4.

Il faut vérifier en outre la condition exprimée par l'équation suivante :

$$\frac{L}{RL} = \frac{R1 \times R2}{R1 + R2} \cdot C1 \quad,$$

en considérant l'inductance comme représentée par un schéma équivalent comportant une partie inductive L et une partie résistive RL en série, pour que la tension $V_{C1}$ aux bornes de la capacité C1 soit indépendante de la tension $V_L$ aux bornes de l'inductance.

Dans une réalisation du dispositif de mesure de courant selon l'invention, la variation de courant de la source de courant en fonction de la température s'effectuant dans un premier sens, l'autre borne de la source de courant est connectée au point de connexion entre les résistances R1 et R2 du réseau.

Dans une autre réalisation du dit dispositif, la variation de courant de la source de courant en fonction de la température s'effectuant dans un second sens, l'autre borne de la source de courant est connectée au point de connexion entre les résistances R3, R4 et la résistance de décalage (Roffset) du circuit de compensation.

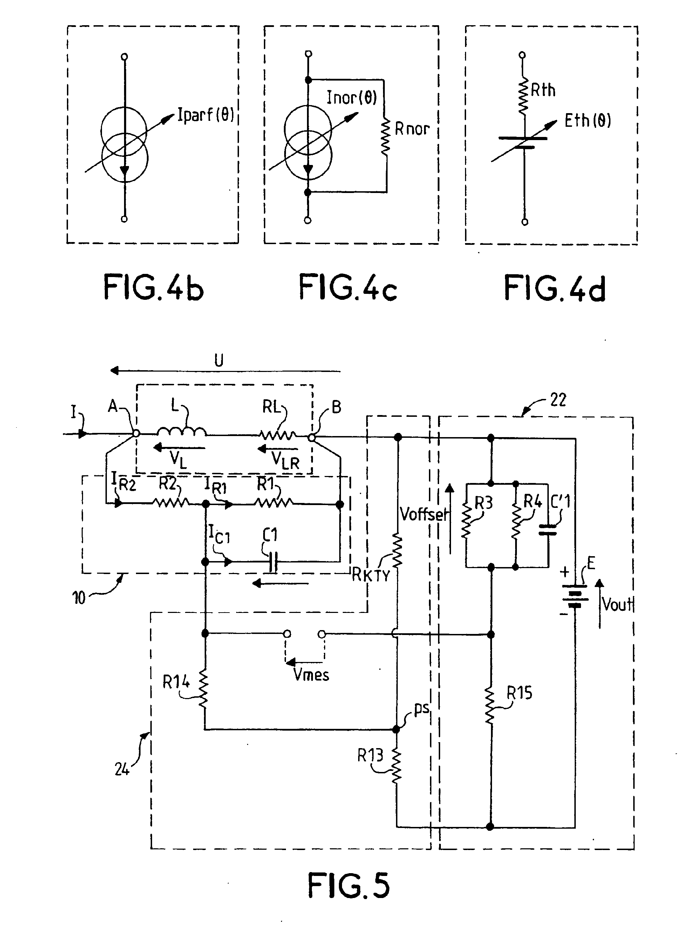

Les figures 4b, 4c et 4d montrent différentes représentations de la source de courant du circuit de compensation en température.

La source de courant contrôlée en fonction de la température θ peut être représentée par :

- un modèle idéal de source de courant Iparf(θ), représenté à la figure 4b ;
- un modèle équivalent de Norton Inor(θ), représenté à la figure 4c, comprenant une source de courant parfaite variant en fonction de la température en parallèle avec une résistance Rnor ;
- un modèle équivalent de Thévenin, représenté à la figure 4d, comprenant une source de tension Eth(θ) variant en fonction de la température en série avec une résistance Rth.

Selon le sens de variation du courant de la source de courant pour la compensation en température, le circuit de compensation en température sera relié par une de ces deux bornes, soit au point commun entre les deux résistances R1 et R2 du réseau, soit au point de connexion entre les résistances R3, R4 et la résistance de décalage (Roffset) du circuit de compensation et par l'autre borne au pôle négatif du générateur E. Dans ce dernier cas le circuit de compensation en température est en parallèle avec la résistance de décalage (Roffset)

Ce dispositif permet, par injection de courant contrôlé en fonction de la température, d'obtenir une tension (Vmes) image du courant dans l'inductance quelle que soit la température de celle-ci.

La source de courant du circuit de compensation en température peut être réalisée de différentes façons, par exemple à partir des tensions aux bornes de réseaux de composants électriques ou électroniques parmi lesquels nous pouvons citer :

- les résistances variables en fonction de la température (résistances platines, résistance silicium par exemple résistance de dénomination commerciale KTY du fabricant « INFINEON » ...);
- les diodes dont la tension de seuil varie avec la température (-2mV/°C);
- ou tout autre circuit électronique fournissant une tension ou un courant dépendant de la température (capteur de température intégré comme le AD590 du fabriquant « Analog Device »...).

Une capacité C1' peut être ajoutée en parallèle sur R3 et R4 afin d'améliorer le fonctionnement du dispositif et augmenter sa précision.

L'invention sera mieux comprise à l'aide d'un exemple de réalisation non limitatif d'un dispositif de mesure selon l'invention en référence aux figures dans lesquelles :

- la figure 1, déjà décrite, représente d'un dispositif de mesure de l'état de l'art du courant traversant une inductance ;
- la figure 2, déjà décrite, représente un dispositif de mesure du courant dans l'inductance de la figure 1, avec un décalage de tension ;
- la figure 3, déjà décrite, représente une courbe de variation du courant de limitation en fonction de la température d'un circuit de limitation de courant utilisant le dispositif de mesure de la figure 2 ;
- la figure 4a, représente un dispositif de mesure de courant dans une inductance dans un cas général de l'invention avec un décalage de tension ;
- les figures 4b, 4c et 4d déjà décrites montrent différentes représentations de la source de courant du circuit de compensation en température
- la figure 5 montre une réalisation à titre d'exemple du dispositif de mesure de courant dans une inductance, selon l'invention
- la figure 6 montre à titre de comparaison les variations du courant de limitation en fonction de la température avec le dispositif selon l'invention (tracé continu) et sans le dispositif (tracé discontinu).

Le schéma de la figure 4a montre un dispositif de mesure de courant dans une inductance dans un cas général de l'invention avec un décalage de tension.

La figure 4a montre :

- l'inductance 12 représentée par son schéma équivalent comportant une partie réactive pure L, en série avec une résistance RL.
- un dispositif de mesure de courant dans l'inductance 12, selon l'invention connecté en parallèle sur l'inductance comportant les deux bornes A et B,

Le dispositif de la figure 4a comporte :

- le réseau 10 tel que représenté à la figure 2 (ou le dispositif de mesure de l'état de l'art de la figure1) en parallèle avec l'inductance 12 connecté aux bornes A et B ayant la résistance R2 en série avec la résistance R1 en parallèle avec la capacité C1,
- un circuit de décalage de tension 16 ayant le générateur E de tension continue Vout connecté en parallèle avec la résistance de décalage Roffset en série avec les deux résistances en parallèle R3 et R4 et au point commun de la résistance R1 et la capacite C1 reliés à la borne B de l'inductance 12. Le pôle négatif du générateur est connecté à la résistance de décalage Roffset ;
- un circuit de compensation en température 20 comportant une source de courant variant en fonction de la température pouvant être représentée par une source de courant parfaite variant en fonction de la température Iparf(θ) (figure 4b), ou par un modèle équivalent de Norton Inor(θ) en parallèle avec une résistance Rnor (figure 4c), ou un modèle équivalent de Thévenin (figure 4d) comprenant une source de tension variant en fonction de la température Eth(θ) en série avec une résistance Rth.

Selon le sens de la variation du courant de la source de compensation en température (générateur de courant), le circuit de compensation en température sera connecté, soit, pour un premier sens de variation du courant, par une de ces deux bornes, au point commun entre les deux résistances R1 et R2 du réseau10 par la connexion S1 représentée en trait discontinu sur la figure 4a, soit, pour le second sens de variation de courant, connectée au point commun de la résistance de décalage et des deux résistances R3 et R4 par la connexion S2 représentée en trait discontinu (soit dans ce second cas en parallèle avec la résistance d'offset Roffset).

La capacité C1' peut être ajoutée en parallèle sur les résistances R3 et R4 afin d'améliorer le fonctionnement du dispositif et augmenter sa précision.

La mesure de tension Vmes image du courant I dans l'inductance 12 est effectué entre le point commun entre les résistances R1, R2 du réseau et le point commun entre la résistance de décalage Roffset et les deux résistances R3 et R4.

La figure 5 montre une première réalisation du dispositif de mesure de courant dans une inductance, selon l'invention.

Le dispositif comporte :

- le réseau 10 tel que représenté à la figure 2 en parallèle avec l'inductance 12 connecté aux bornes A et B ayant la résistance R2 en série avec la résistance R1 en parallèle avec la capacité C1,
- une circuit de décalage de tension 22 comportant le générateur E connecté en parallèle avec une résistance de décalage R15 (ou résistance d'offset) en série avec deux résistances R3 et R4 en parallèle. Le pôle positif du générateur E est connecté au point commun des deux résistances R3 et R4 du coté de ces résistances et au point commun de la résistance R1 et la capacité C1 reliés à la borne B de l'inductance 12, le pôle négatif du générateur E étant relié à la résistance de décalage R15.
- un circuit de compensation en température 24 comportant une résistance R14 reliée par une de ces deux bornes au point commun entre les deux résistances R1 et R2 du réseau et par l'autre borne à une sortie ps d'un pont diviseur comportant une résistance R13 en série avec une thermistance RKTY (ref: KTY 13-6 de INFINEON), le pont diviseur étant connecté, du coté de la thermistance RKTY au pole positif du générateur E et du côté de la résistance R13 au pôle négatif du générateur E.

La source de tension Eth de compensation en température (figure 4d) est obtenue dans le cas de la réalisation de la figure 5, par la tension du point commun entre les résistances RKTY et R13.

Une capacité C1' est connectée en parallèle sur R3 et R4 afin d'améliorer le fonctionnement du dispositif et augmenter sa précision.

La mesure de tension Vmes image du courant I dans l'inductance 12 est effectuée entre le point commun des résistances R15, R3, R4 et le point commun des résistances R14, R1, R2.

Nous allons par la suite exprimer les relations existant entre les différents éléments du dispositif selon l'invention représente à la figure 5.

La résistance RL représente la résistance intrinsèque de l'inductance 12. La résistance RL varie en température et sans circuit de compensation il se produit une erreur de mesure du courant dans l'inductance.

Nous allons considérer, à titre d'exemple, le cas d'utilisation du dispositif de mesure selon l'invention de la figure 5 dans un convertisseur de tension à découpage fonctionnant avec une fréquence de découpage F, ayant un circuit de limitation de courant (non représenté sur les figures). Le circuit de limitation comporte essentiellement un comparateur à seuil recevant d'une part la tension Vmes image du courant dans l'inductance 12 et d'autre part une tension de seuil Vcomp représentant un courant maximum à ne pas dépasser. Dans l'exemple de réalisation de la figure 5, les valeurs des composants sont :

$$RL0 = 8m\Omega \text{ pour une température ambiante } T0 = 25°C$$

La résistance de l'inductance RL(T) en fonction de la température est donnée par

$$RL(T) = RL0.[1 + 0,0038(T - T0)]$$

Le schéma de la figure 5 permet une compensation thermique de la mesure du courant pour obtenir une limitation de courant maximum indépendante de la température. A cet effet on utilise une thermistance RKTY à base de silicium dont la résistance varie de façon sensiblement linéaire en fonction de la température.

$$RKTY0 = 2000\Omega \text{ ,}$$

RKTY0 pour une température ambiante de T0=25°C

$$RKTY(T) = RKTY0.[1 + 7,88.10^{-3}.(T - T0) + 19,37.10^{-6}.(T - T0)^2]$$

Le système sera dimensionné entre les deux températures extrêmes Th et Tb. Il s'agit de la température de l'inductance à pleine puissance, comprenant donc la température ambiante externe ajoutée à l'élévation de température interne du boîtier dans lequel peut se trouver l'inductance ainsi que celle de l'inductance.

La mesure de courant Vmes est appliquée à une entrée du circuit comparateur de courant (non représenté sur les figures). Le seuil maximum Vcomp du courant Vmes correspondant à un courant Imax de limitation est appliquée à l'autre entrée du comparateur. Par exemple dans cette réalisation :

$$Vcomp = 75mV$$

La tension Voffset à appliquer en entrée du comparateur, lorsque le courant est nul, est :

$$Voffset = 3mV$$

Le courant maximum Imax de sortie du convertisseur (courant moyen dans l'inductance) est :
Imax =8A, pour un courant nominal

Comme cela a été dit précédemment, pour obtenir une mesure correcte de courant dans l'inductance, la relation suivante doit être respectée :

$$R_{1P2} \cdot C1 = \frac{L}{RL}$$

$R_{1P2}$ étant la résistance équivalente à R1 et R2 en parallèles.

Comme RL varie en température, en pratique, on peut choisir la valeur médiane Rlmed.

R13 sera choisie à priori pour obtenir une tension de pont (RKTY, R13) qui évolue significativement en température tout en limitant le courant dans RKTY pour éviter les auto échauffements.

Il est donc possible d'exprimer la relation reliant Vmes et le courant I dans l'inductance de la façon suivante :

$$Vmes = \frac{R2 \cdot R14}{(R1 + R2) \cdot (R_{1P2} + R14)} \cdot RL \cdot I + Vout \cdot \left( \frac{R_{1P2}}{R_{1P2} + R15} - \frac{RKTY}{RKTY + R13} \cdot \frac{R_{1P2}}{R_{1P2} + R14} \right)$$

avec RL(T) résistance de l'inductance en fonction de la température
avec RKTY(T) résistance variable en fonction de la température

Le calcul du courant de limitation Ilim réglé par la tension de seuil sur le comparateur est donné par l'expression :

$$I\lim Comp(T) = \frac{Vcomp + Vout \cdot \left( \frac{R_{1P2}}{R_{1P2} + R14} \cdot \frac{RKTY(T)}{RKTY(T) + R13} - \frac{R_{1P2}}{R_{1P2} + R15} \right)}{\frac{R2}{R2 + R1} \cdot \frac{R14}{R14 + R_{1P2}} \cdot RL(T)}$$

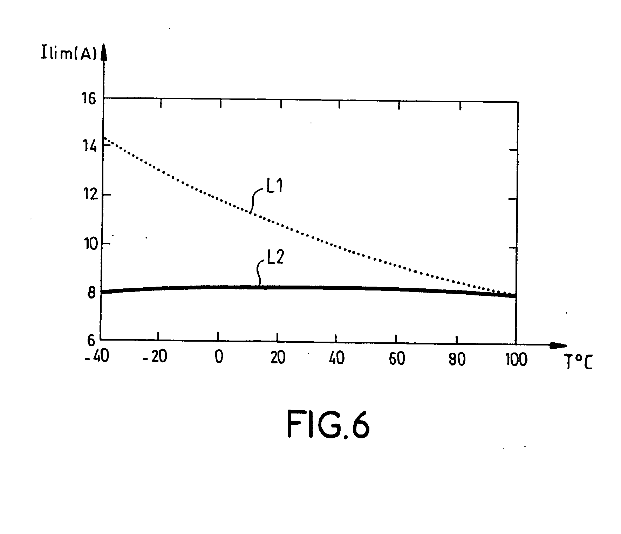

Les courbes de la figure 6 montrent les variations du courant de limitation Ilim en fonction de la température T en degrés, la courbe L1 montrant cette variation dans le cas d'un système non équipé du dispositif de l'invention, la courbe L2 dans le cas d'un système équipé du dispositif de mesure selon l'invention. Ces courbes permettent de constater l'efficacité du dispositif de mesure selon l'invention, la variation de courant de limitation avec le dispositif compensé en température selon l'invention étant quasiment nulle.

**Revendications**

1. Dispositif de mesure de courant dans une inductance (12) destiné à être connecté en parallèle sur ladite inductance comportant deux bornes A et B ayant

   - un réseau en parallèle (10) avec l'inductance connecté aux bornes A B ayant une résistance R2 en série avec une résistance R1 en parallèle avec une capacité C1, **caractérisé en ce qu'**il comporte:
   - un circuit de décalage de tension (14, 16, 22) ayant un générateur E de tension continue connecté en parallèle avec une résistance de décalage (Roffset, R15) en série avec deux résistances en parallèle R3 et R4, le pôle positif du générateur étant connecté au point commun des deux résistances R3 et R4 et au point commun de la résistance R1 et la capacité C1 du réseau destiné à être connecté à une des deux bornes de l'inductance, le pôle négatif du générateur E étant connecté à la résistance de décalage ;
   - un circuit de compensation en température (20, 24) comportant une source de courant contrôlée en fonction de la température, une des deux bornes de la source de courant étant connectée au pôle négatif du générateur E, l'autre borne de la source de courant étant connectée à des points différents du dispositif de mesure selon le sens de la variation du courant de la source en fonction de la température ;

   et **en ce que** la mesure de tension Vmes, image du courant dans l'inductance, est effectuée entre le point commun des résistances R1, R2 du réseau et le point commun de la résistance de décalage et des deux résistances R3 et R4.

2. Dispositif de mesure de courant selon la revendication 1, **caractérisé en ce que** l'inductance étant équivalente à une partie inductive pure L en série avec une partie résistive RL le réseau en parallèle avec l'inductance vérifiant la condition exprimée par la relation :

$$\frac{L}{RL} = \frac{R1 \times R2}{R1 + R2} \times C1$$

pour que la tension $V_{C1}$ aux bornes de la capacité C1 soit indépendante de la tension $V_L$ aux bornes de l'inductance.

**3.** Dispositif de mesure de courant selon l'une des revendications 1 ou 2, **caractérisé en ce que**, la variation de courant de la source de courant en fonction de la température s'effectuant dans un premier sens, l'autre borne de la source de courant est connectée au point de connexion entre les résistances R1 et R2 du réseau.

**4.** Dispositif de mesure de courant selon l'une des revendications 1 ou 2, **caractérisé en ce que**, la variation de courant de la source de courant en fonction de la température s'effectuant dans un second sens, l'autre borne de la source de courant est connectée au point de connexion entre les résistances R3, R4 et la résistance de décalage (Roffset) du circuit de compensation.

**5.** Dispositif de mesure de courant selon l'une des revendications 1 à 4, **caractérisé en ce que** la source de courant du circuit de compensation en température (20, 24) peut être réalisée de différentes façons, par exemple à partir des tensions aux bornes de réseaux de composants électriques ou électroniques parmi lesquels nous pouvons citer :

- les résistances variables en fonction de la température (résistances platines, résistance silicium, par exemple résistance de dénomination commerciale KTY du fabriquant « INFINEON » ...) ;
- les diodes dont la tension de seuil varie avec la température (-2mV/°C);
- ou tout autre circuit électronique fournissant une tension ou un courant dépendant de la température (capteur de température intégré comme le AD590 du fabriquant « Analog Device »...).

**6.** Dispositif de mesure de courant selon l'une des revendications 1 à 3, **caractérisé en ce qu'**il comporte :

- le réseau (10) en parallèle avec l'inductance (12) connecté aux bornes A et B ayant la résistance R2 en série avec la résistance R1 en parallèle avec la capacité C1,
- un circuit de décalage de tension (22) comportant le générateur E connecté en parallèle avec une résistance de décalage R15 (ou résistance d'offset) en série avec deux résistances R3 et R4 en parallèle, le pôle positif du générateur E étant connecté au point commun des deux résistances R3 et R4 du coté de ces résistances et au point commun de la résistance R1 et la capacité C1 reliés à la borne B de l'inductance 12, le pôle négatif du générateur E étant relié à la résistance de décalage R15.
- un circuit de compensation en température (24) comportant une résistance R14 reliée par une de ces deux bornes au point commun entre les deux résistances R1 et R2 du réseau et par l'autre borne à une sortie ps d'un pont diviseur comportant une résistance R13 en série avec une thermistance RKTY, le pont diviseur étant connecté, du coté de la thermistance RKTY au pole positif du générateur E et du côté de la résistance R13 au pôle négatif du générateur E.

**7.** Dispositif de mesure de courant selon la revendication 6, **caractérisé en ce que** la thermistance RKTY est à base de silicium dont la résistance varie de façon sensiblement linéaire en fonction de la température.

**8.** Dispositif de mesure de courant selon l'une des revendications 1 à 7, **caractérisé en ce qu'**il comporte une capacité C1' en parallèle sur les résistances R3 et R4.

**Claims**

**1.** Device for measuring current in an inductor (12), which device is intended to be connected in parallel with said inductor, comprising two terminals A and B, and has a network in parallel (10) with the inductor and connected to the terminals A and B having a resistor R2 in series with a resistor R1 in parallel with a capacitor C1, **characterized in that** it comprises:

- a voltage offset circuit (14, 16, 22) having a DC voltage generator E connected in parallel with an offset resistor (Roffset, R15) in series with two resistors in parallel R3 and R4, the positive pole of the generator being connected to the common point of the two resistors R3 and R4 and to the common point of the resistor R1 and the capacitor C1 of the network intended to be connected to one of the two terminals of the inductor, the negative pole of the generator E being connected to the offset resistor;
- a temperature compensation circuit (20, 24) comprising a current source controlled as a function of the temperature, one of the two terminals of the current source being connected to the negative pole of the generator E, the other terminal of the current source being connected to different points of the measurement device according to the direction of variation of the current of the source as a function of the temperature;

and **in that** the measurement of voltage Vmes, the image of the current in the inductor, is performed between the common point of the resistors R1, R2 of the network and the common point of the offset resistor and of the two resistors R3 and R4.

2. Device for measuring current according to Claim 1, **characterized in that** the inductor being equivalent to a pure inductive part L in series with a resistive part RL the network in parallel with the inductor satisfies the condition expressed by the relation:

$$\frac{L}{RL} = \frac{R1 \times R2}{R1 + R2} \times C1$$

so that the voltage $V_{C1}$ across the terminals of the capacitor C1 is independent of the voltage $V_L$ across the terminals of the inductor.

3. Device for measuring current according to either of Claims 1 or 2, **characterized in that**, the variation in current of the current source as a function of the temperature being effected in a first direction, the other terminal of the current source is connected to the point of connection between the resistors R1 and R2 of the network.

4. Device for measuring current according to either of Claims 1 or 2, **characterized in that**, the variation in current of the current source as a function of the temperature being effected in a second direction, the other terminal of the current source is connected to the point of connection between the resistors R3, R4 and the offset resistor (Roffset) of the compensation circuit.

5. Device for measuring current according to one of Claims 1 to 4, **characterized in that** the current source of the temperature compensation circuit (20, 24) may be embodied in various ways, for example on the basis of voltages across the terminals of networks of electrical or electronic components among which we may cite:

    - temperature dependent variable resistors (platinum resistors, silicon resistor, for example resistor known commercially as KTY from the manufacturer "INFINEON" ...);
    - diodes whose threshold voltage varies with temperature (-2 mV/°C);
    - or any other electronic circuit providing a temperature dependent voltage or current (integrated temperature sensor such as the AD590 from the manufacturer "Analog Device"...).

6. Device for measuring current according to one of Claims 1 to 3, **characterized in that** it comprises:

    - the network (10) in parallel with the inductor (12) and connected to the terminals A and B having the resistor R2 in series with the resistor R1 in parallel with the capacitor C1,
    - a voltage offset circuit (22) comprising the generator E connected in parallel with an offset resistor R15 in series with two resistors R3 and R4 in parallel, the positive pole of the generator E being connected to the common point of the two resistors R3 and R4 on the side of these resistors and to the common point of the resistor R1 and the capacitor C1 linked to the terminal B of the inductor 12, the negative pole of the generator E being linked to the offset resistor R15;
    - a temperature compensation circuit (24) comprising a resistor R14 linked by one of these two terminals to the common point between the two resistors R1 and R2 of the network and by the other terminal to an output ps of a divider bridge comprising a resistor R13 in series with a thermistor RKTY, the divider bridge being connected, on the side of the thermistor RKTY to the positive pole of the generator E and on the side of the resistor R13 to the negative pole of the generator E.

7. Device for measuring current according to Claim 6, **characterized in that** the thermistor RKTY is based on silicon, the resistance of which varies in a substantially linear manner as a function of the temperature.

8.  Device for measuring current according to one of Claims 1 to 7, **characterized in that** it comprises a capacitor C1' in parallel with the resistors R3 and R4.

**Patentansprüche**

1.  Vorrichtung zur Strommessung in einer Drosselspule (12), die dazu bestimmt ist, parallel zur Drosselspule angeschlossen zu werden, die zwei Klemmen A und B aufweist:

    - wobei die Vorrichtung ein zur Drosselspule parallelgeschaltetes Netz (10) aufweist, das mit den Klemmen A und B verbunden ist und einen Widerstand R2 in Reihe mit der Parallelschaltung eines Widerstands R1 und eines Kondensators C1 aufweist,

    **dadurch gekennzeichnet, dass** die Vorrichtung aufweist:

    - eine Spannungsoffsetschaltung (14, 16, 22) mit einem Gleichspannungsgenerator E, der mit einem Offsetwiderstand (Roffset, R15) in Reihe mit der Parallelschaltung zweier Widerstände R3 und R4 parallelgeschaltet ist, wobei der positive Pol des Generators mit dem gemeinsamen Punkt der zwei Widerstände R3 und R4 und mit dem gemeinsamen Punkt des Widerstands R1 und des Kondensators C1 des Netzes verbunden ist, der dazu bestimmt ist, mit einer der beiden Anschlussklemmen der Drosselspule verbunden zu werden, während der negative Pol des Generators E mit dem Offsetwiderstand verbunden ist;
    - eine Temperaturkompensations-Schaltung (20, 24), die eine temperaturabhängig gesteuerte Stromquelle aufweist, wobei eine der beiden Anschlussklemmen der Stromquelle mit dem negativen Pol des Generators E verbunden ist, während die andere Anschlussklemme der Stromquelle mit unterschiedlichen Punkten der Messvorrichtung verbunden ist, je nach der Richtung der Änderung des Stroms der Quelle in Abhängigkeit von der Temperatur;

    und dass die Spannungsmessung Vmes, die ein Abbild des Stroms in der Drosselspule ist, zwischen dem gemeinsamen Punkt der Widerstände R1, R2 des Netzes und dem gemeinsamen Punkt des Offsetwiderstands und der beiden Widerstände R3 und R4 erfolgt.

2.  Strommessvorrichtung nach Anspruch 1, **dadurch gekennzeichnet, dass**, da die Drosselspule einem rein induktiven Bereich L in Reihe mit einem ohmschen Bereich RL entspricht, das mit der Drosselspule parallelgeschaltete Netz die durch die folgende Beziehung ausgedrückte Bedingung erfüllt:

$$\frac{L}{RL} = \frac{R1 \times R2}{R1 + R2} \times C1$$

    damit die Spannung $V_{C1}$ an den Klemmen des Kondensators C1 von der Spannung $V_L$ an den Klemmen der Drosselspule unabhängig ist.

3.  Strommessvorrichtung nach einem der Ansprüche 1 oder 2, **dadurch gekennzeichnet, dass**, wenn die Stromänderung der Stromquelle in Abhängigkeit von der Temperatur in einer ersten Richtung erfolgt, die andere Klemme der Stromquelle mit dem Verbindungspunkt zwischen den Widerständen R1 und R2 des Netzes verbunden ist.

4.  Strommessvorrichtung nach einem der Ansprüche 1 oder 2, **dadurch gekennzeichnet, dass**, wenn die Stromänderung der Stromquelle in Abhängigkeit von der Temperatur in einer zweiten Richtung erfolgt, die andere Klemme der Stromquelle mit dem Verbindungspunkt zwischen den Widerständen R3, R4 und dem Offsetwiderstand (Roffset) der Kompensations-Schaltung verbunden ist.

5.  Strommessvorrichtung nach einem der Ansprüche 1 bis 4, **dadurch gekennzeichnet, dass** die Stromquelle der Temperaturkompensations-Schaltung (20, 24) auf verschiedene Weise realisiert werden kann, zum Beispiel ausgehend von den Spannungen an den Klemmen von Netzen von elektrischen oder elektronischen Bauteilen, unter denen erwähnt werden können:

- die temperaturabhängig variablen Widerstände (Platin-Widerstände, Silicium-Widerstand, zum Beispiel ein Widerstand mit der Handelsbezeichnung KTY des Herstellers "INFINEON" ...) ;
- die Dioden, deren Schwellenspannung mit der Temperatur variiert (-2mV/°C);
- oder jede andere elektronische Schaltung, die eine temperaturabhängige Spannung oder einen temperaturabhängigen Strom liefert (integrierter Temperaturmessfühler wie der AD590 des Herstellers "Analog Device", ...).

6. Strommessvorrichtung nach einem der Ansprüche 1 bis 3, **dadurch gekennzeichnet, dass** sie aufweist :

- das zur Drosselspule (12) parallelgeschaltete Netz (10), das mit den Klemmen A und B verbunden ist und dessen Widerstand R2 mit dem Widerstand R1 in Reihe geschaltet ist, welcher mit dem Kondensator C1 parallelgeschaltet ist,
- eine Spannungsoffsetschaltung (22), die den zu einem Offsetwiderstand R15 parallelgeschalteten Generator E aufweist, der mit der Parallelschaltung zweier Widerstände R3 und R4 in Reihe geschaltet ist, wobei der positive Pol des Generators E mit dem gemeinsamen Punkt der zwei Widerstände R3 und R4 auf der Seite dieser Widerstände und mit dem gemeinsamen Punkt des Widerstands R1 und des Kondensators C1 verbunden ist, die mit der Klemme B der Drosselspule 12 verbunden sind, während der negative Pol des Generators E mit dem Offsetwiderstand R15 verbunden ist,
- und eine Temperaturkompensations-Schaltung (24), die einen Widerstand R14 aufweist, der über eine dieser beiden Klemmen mit dem gemeinsamen Punkt zwischen den beiden Widerständen R1 und R2 des Netzes und über die andere Klemme mit einem Ausgang ps einer Teilerbrücke verbunden ist, die einen mit einem Thermistor RKTY in Reihe geschalteten Widerstand R13 aufweist, wobei die Teilerbrücke auf der Seite des Thermistors RKTY mit dem positiven Pol des Generators E und auf der Seite des Widerstands R13 mit dem negativen Pol des Generators E verbunden ist.

7. Strommessvorrichtung nach Anspruch 6, **dadurch gekennzeichnet, dass** der Thermistor RKTY aus Silicium ist, dessen Widerstand in Abhängigkeit von der Temperatur im Wesentlichen linear variiert.

8. Strommessvorrichtung nach einem der Ansprüche 1 bis 7, **dadurch gekennzeichnet, dass** sie einen Kondensator C1' aufweist, der mit den Widerständen R3 und R4 parallelgeschaltet ist.

**FIG.1**

**FIG.2**

FIG.3

FIG.4a

FIG.4b        FIG.4c        FIG.4d

FIG.5

FIG.6